# EUROPEAN PATENT APPLICATION

(11) **EP 1 265 163 A1**
(43) Date of publication of application: **11.12.2002**
(21) Application number: 01401477.3
(22) Date of filing: 07.06.2001
(51) Int. Cl.: G06F 17/50

(54) **Method and apparatus for logic layout with controlled placement of structured cells**

(71) Applicant: Texas Instruments Incorporated, Dallas, Texas 75251 (US); Texas Instruments France, 06271 Villeneuve Loubet Cedex, Nice (FR)
(72) Inventor: Raibaut, Claudine, 06480 LaColle/Loup (FR); Ponsot, Eric, 06140 Vence (FR); Boutel, Laurent, 06000 Nice (FR)
(74) Representative: Holt, Michael

(57) **Abstract**

A layout system (10) includes a place and route tool (12) and a datapath layout generator. The datapath layout generator (14) provides a mechanism for the designer to place datapath cells in a structured arrangement. The datapath layout generator (14) sends a language configuration file to the place and route tool (12) to install the datapath structure. The datapath structure assigned "fixed" status, which prevents the place and route tool (12) from moving the datapath cells in later operations. Constraints for the remaining cells are then installed in the place and route tool (12), and criteria-driven placement, such as timing-driven placement, can be used to arrange these cells in an optimum fashion. The remaining cells can be placed in open areas of the datapath structure for improved density.

## Description

### TECHNICAL FIELD OF THE INVENTION

This invention relates in general to integrated circuits and, more particularly, to a method and apparatus for electronic design automation.

### DESCRIPTION OF THE RELATED ART

In the design of integrated circuits, a "place and route" tool is often used to aid the physical layout of a circuit. After the logic for a circuit is designed and tested, the cells of the circuit must be arranged in such a manner that desired timing (and other) constraints are met. A place and route tool can iterate through different layouts and evaluate timing constraints for each layout until a suitable solution is reached.

As integrated circuits become denser, the layout of the circuit with respect to timing constraints becomes more critical and difficult. In a design that combines a large number of gates and aggressive timing criteria, it can be extremely difficult for a place and route tool to complete its task. In cases with many timing constraints, the place and route tool may not be able to complete all routes, as some constraints may be impossible to meet, or the number of iterations needed may be unacceptable.

Therefore, a need has arisen for a place and route system that allows flexible placement of critical paths to meet aggressive timing performances.

### Brief Summary of the Invention

In the present invention, an integrated circuit design includes datapath cells in a structured layout and other cells in an unstructured layout. A description of a desired layout for the datapath cells is generated and transferred to a place and route tool, in order to assign the desired layout to the datapath cells within the place and route tool. The datapath cells are assigned a predetermined status to prevent movement of the cells. Constraint information regarding the other cells is then transferred to the place and route tool and optimization procedures may be performed on the layout based on desired criteria, such that the datapaths cells are unmoved as different layout iterations are performed on the other cells.

The present invention provides several advantages over the prior art. The approach described above allows the layout designer to address both timing performance and density. Structured cells may be place in matrices that are not "hard macros"; therefore, they can be any shape that makes sense from a timing point of view. The placer can take advantage of the free space within matrices for improving density. Overall timing-driven placement is improved, since the place and route tool always has a global view of all timing constraints and can optimize the layout of no-fixed cell placements.

### BRIEF DESCRIPTION OF THE SEVERAL VIEWS OF THE DRAWINGS

For a more complete understanding of the present invention, and the advantages thereof, reference is now made to the following descriptions taken in conjunction with the accompanying drawings, in which:
Fig. 1 illustrates a block diagram of a system incorporating a place and route tool with enhanced control over the layout of structured elements;
Fig. 2 illustrates a flow chart describing the operation of the system of Fig. 1;
Fig. 3a illustrates a matrix used to define the layout of cells in the place and route tool;
Fig. 3b illustrates spacing between matrix rows;
Fig. 3c illustrates the use of spacing between rows to achieve interleaved matrices; and
Fig. 4 illustrates space left in structured layout matrices used for unstructured cells.

### DETAILED DESCRIPTION OF THE INVENTION

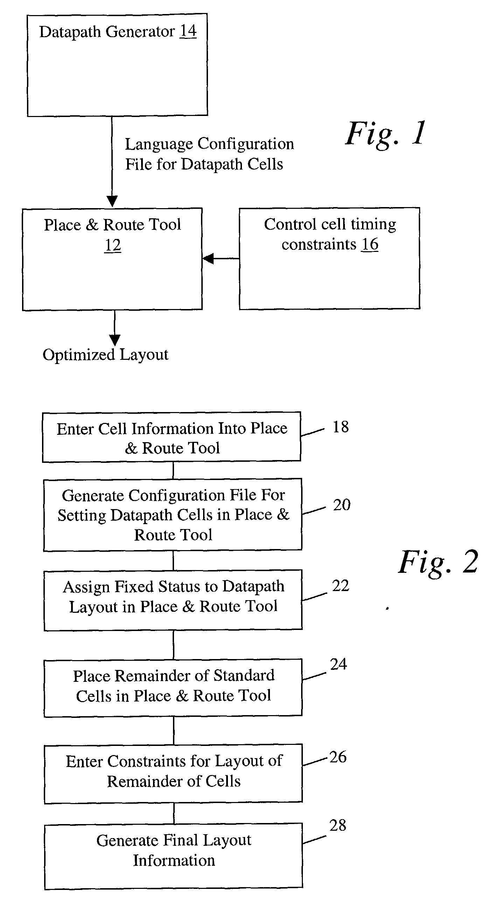

The present invention is best understood in relation to Figures 1-4 of the drawings, like numerals being used for like elements of the various drawings.

Figure 1 illustrates a block diagram showing the overall structure of a system 10 for placing and routing cells in a complex circuit that provides full control on the placement of highly critical structured logic. A place and route tool 12, receives information from a datapath generator 14 that defines the desired layout for the structured logic (also referred to herein as the "datapath" cells) in a language configuration file compatible with the place and route tool. Information for the remainder of the cells (also referred to herein as the "control" or "unstructured" cells) is input from input source 16, which could be a file or input device. The datapath generator 14 and place and route tool 12 may be implemented on the same or separate workstations or similar computing devices.

Figure 2 is a flowchart describing the basic operation of the system 10 of Figure 1. In block 18, the cell information for the circuit is entered into the place and route tool 12. In block 20, the datapath generator 12, which is a program that generates a file describing the desired layout information for the datapath cells, generates a configuration file. This configuration file defines the layout of the datapath cells of the circuit. The datapath generator 14 allows the layout designer to have complete control of the placement of these cells. This aspect is described in greater detail hereinbelow.

In block 22, the datapath logic layout is "fixed" in the place and route tool 12. In the AVANT! APOLLO product, cells may be fixed through assignment of a "fixed" status to the cells, which provides the highest layout priority; the placement location of these cells is guaranteed as other cells are moved to optimize timing performance.

In step 24, timing (or other) constraints for the remaining unstructured cells (the "control logic") are submitted to the place and route tool 12. The place and route tool 12 can optimize the layout in step 26, without affecting the previously-fixed placement of the datapath logic. When timing (or other) constraints are met, the layout information can be generated in block 28.

The present invention as described in Figures 1 and 2 provides the layout designer with the ability to carefully and flexibly place critical structured logic in a desired arrangement, which will not be affected by subsequent optimization routines by the place and route tool 12.

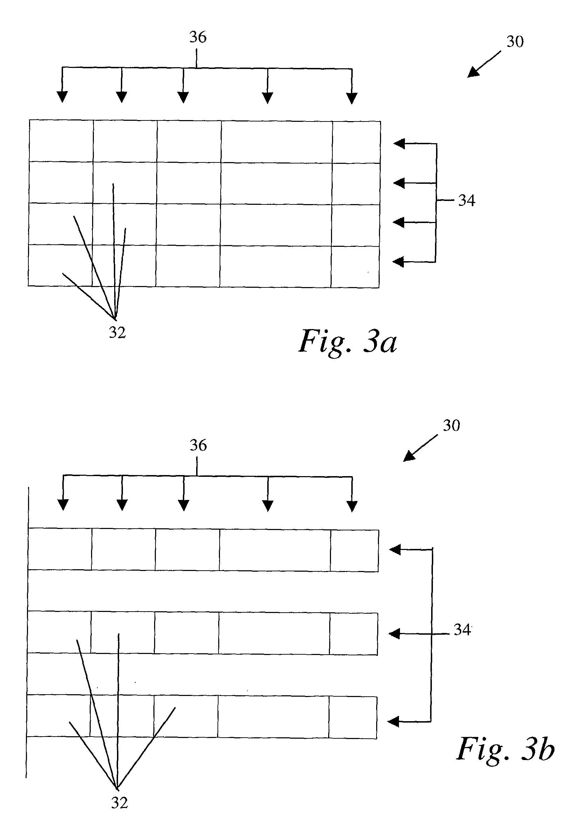

Figures 3a-c illustrate the placement of the structured logic in greater detail. The illustrated embodiment uses the operation of the AVANT! APOLLO place and route tool as an example of how the structured datapath logic can be allocated in a place and route tool; other products may use different methods of allocating cells in a matrix.

Figure 3a illustrates an empty matrix 30. A cell matrix is defined, at a minimum, by a unique name, a number of rows 34 and a number of columns 36. Each slot 32 of an empty matrix is initially square, i.e., the height and width of each slot 32 is the height of the unit tile cell. Each slot 32 is assigned a row and column number. Once a cell is assigned to a slot 32, the corresponding matrix column 36 is enlarged according to the cell width of the slot 32.

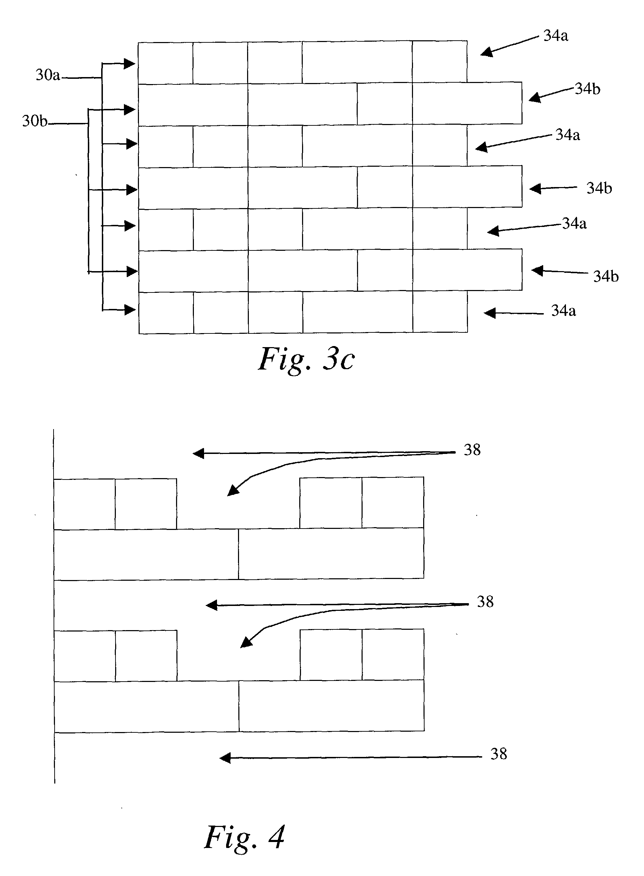

Column and row space can be adjusted by adding extra space between rows 34 or between columns 36. In Figure 3b, extra space 38 is added between rows 34. This feature can be used to allow two or more matrices to be interleaved, as shown in Figure 3c by matrices 30a and 30b, having rows 34a and 34b, respectively. Accordingly, datapaths made of cells of different widths can be efficiently placed. Using this method, complex datapaths can be built using basic standard cells, without the need for custom cell development. It should be noted that two or more matrices may be interleaved using interleaved columns, as well as interleaved rows as shown in Figure 3c.

When timing-driven tools have difficulties with complex constraints, the datapath matrix (or matrices) can ensure timings for the critical paths. By adjusting column and row spacing, free space 38 can be planned within the matrix to allow timing-driven placement of embedded standard cells along with the structured placement cells. Figure 4 illustrates free space 38 within one or more matrices for further placement of timing-driven unstructured cells. It has been found that this approach provides improved density by increasing the percentage of area utilization (by gates) compared to an approach where datapath blocks are placed as embedded hard macros.

Implementation of the method of Figure 2 requires three parts: logic synthesis, datapath description file, and placement automation. These aspects are described below.

To have more control over the way the logic synthesis is done to achieve the expected netlist, datapaths are descried as dedicated modules. Also, each datapath basic element is described as a "box", either containing a basic RTL (register transfer level) description for the involved function, or direct instantiation of the involved cell.

All datapath modules are instantiated within the RTL description of the integrated circuit, leading to a structural type of description. Once the RTL description is ready, logic synthesis is performed using a bottom-up approach: datapath basic elements are synthesized first and the top level is synthesized using the "fixed" attribute on basic element instances. For accurate timing analysis, the net loads corresponding to structural placements are annotated either from the previous layout run or from estimated load values.

Once the DSP core netlist is ready, the involved instances can be identified and collected through wildcards and a description file for the corresponding matrix can be easily built. The syntax of the description file is very simple and the requested information about the involved matrices are: matrix name, number of rows, number of columns, space between rows, space between columns, matrix location, strap pitch and involved instances per row. Strap pitch allows planning for vertical power ground straps by adding convenient space at locations within the matrices.

Location can be absolute or relative to the location of another matrix. Relative location is useful for cases of further floorplan updates. If the floorplan is changed and if the location of all matrices depends on the location of the reference matrix, then the only requested manual change will be to move the latter matrix. Also, this feature allows the designer to try various datapath implementations, since the cost of manual intervention is very low.

Rows are concisely described using patterns and indices. Three examples are:
ROWx="pattern" index_start= index_end= index step= pattern_width=
ROWx="pattern1 pattern2" index_start= index_end= index step=
   pattern_width=
ROWx="pattern1" index_start= index_end= index step= pattern_width=,
   "pattern2" index_start= index_end= index step= pattern_width=,
   "pattern3" index_start= index_end= index step= pattern_width=

From this description file, the Datapath generator produces a full scheme language configuration file for involved matrices, allowing installation of structured placement within the floorplan.

An example of a description file is:

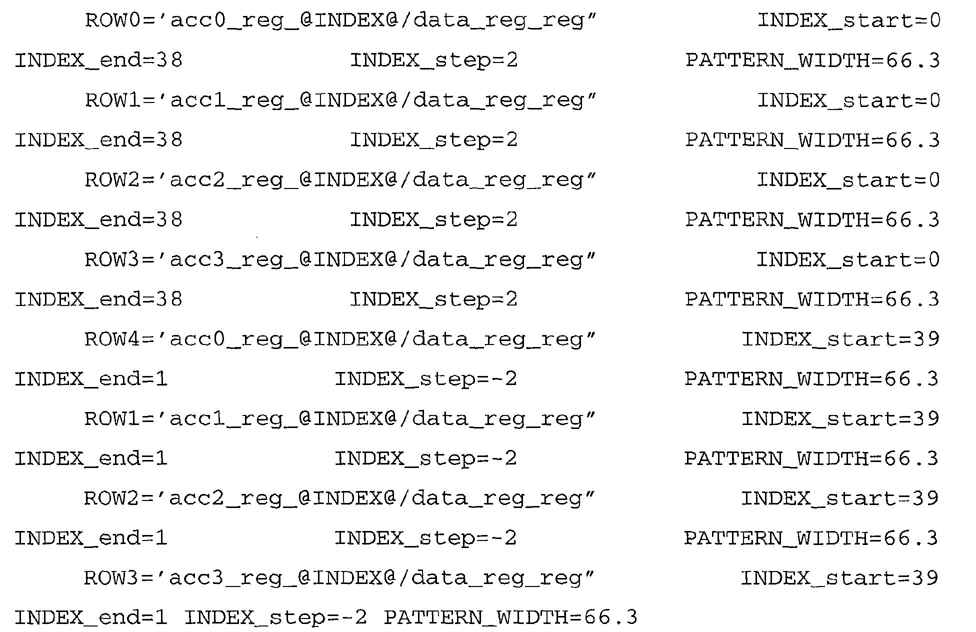

The eight-line description set forth above provides placement for 152 cells within the regular structure.

Once all description files are generated for the datapaths, the datapath generator 14 passes the language configuration file to the place and route tool 12 to install all datapath logic within the floorplan, taking into account power/ground pre-routing. If relative placements are used, rework in order to try various placement scenarios or in case of floorplan change will be minimal.

When all floorplan matrices are installed within the floorplan, all involved cells are pre-placed with the fixed status, which is the highest priority. After all structure placements are installed, the usual place and route procedures are executed. The constraints for the rest of the standard unstructured cells are input into the place and route tools, and are placed using automated procedures, such as timing-driven placement. These procedures may make use of the porosity of the datapath matrices to place the rest of the standard cells.

If favorable to placement criteria, such as timing specification, and if free space is available among structured placement, standard cells can be placed within datapaths. Then routing can be performed to complete the layout.

The present invention provides several advantages over the prior art. The approach described above allows the layout designer to address both timing performance and density. Matrices are not "hard macros"; therefore, they can be any shape that makes sense from a timing point of view. The placer can take advantage of the free space within matrices for improving density. Overall timing-driven placement is improved, since the place and route tool always has a global view of all timing constraints and can optimize the layout of no-fixed cell placements.

Although the Detailed Description of the invention has been directed to certain exemplary embodiments, various modifications of these embodiments, as well as alternative embodiments, will be suggested to those skilled in the art. The invention encompasses any modifications or alternative embodiments that fall within the scope of the Claims.

## Claims

1. A method of controlling layout of cell in an integrated circuit including datapath cells in a structured layout and other cells in an unstructured layout, which method comprising:
generating a description of a desired layout for the datapath cells;
transferring said description to a place and route tool to assign the desired layout to the datapath cells within the place and route tool;
assigning a status to the datapath cells to prevent movement of the cells;
transferring desired criteria regarding the other cells to the place and route tool; and
optimizing the layout based on said desired criteria, such that the datapaths cells are unmoved as different layout iterations are performed on the other cells.

2. The method of claim 1, further comprising:
inputting information on said datapath and other cells to the place and route tool.

3. The method of claim 1 or 2, wherein said step of generating a description comprises the step of:
generating one or more matrices for defining placement of said datapath cells.

4. The method of claim 3, wherein said step of generating one more matrices comprises the step of:
generating two or more matrices with interleaved rows.

5. The method of claim 3, wherein said step of generating one more matrices comprises the step of:
generating two or more matrices with interleaved columns.

6. The method of claim 3, wherein said step of generating matrices comprises the step of:
generating matrices leaving free space between slots for datapath cells in which ones of said other cells may be placed.

7. The method of any of claims 1-6, wherein said step of transferring desired criteria comprises the step of:
transferring timing criteria for the other cells to the place and route tool.

8. Apparatus for controlling layout of cell in an integrated circuit including datapath cells in a structured layout and other cells in an unstructured layout, which apparatus comprising:
a place and route tool;
datapath generator for generating a description of a desired layout for the datapath cells and for transferring said description to a place and route tool to assign the desired layout to the datapath cells within the place and route tool;
wherein a status can be assigned to the datapath cells in said place and route tool to prevent movement of the cells during optimization of the layout of said other cells.

9. The apparatus of claim 8, wherein said place and route tool is arranged for receiving information on said datapath and other cells.

10. The apparatus of claim 8 or 9, wherein said datapath generator is arranged for generating a description of one or more matrices for defining placement of said datapath cells.

11. The apparatus of claim 10, wherein said datapath generator is arranged for generating a description of two or more matrices with interleaved rows.

12. The apparatus of claim 10 wherein said datapath generator is arranged for generating a description of two or more matrices with interleaved columns.

13. The apparatus of claim 10 wherein said datapath generator generates a description of a plurality of matrices for datapath cells leaving free space between slots of said matrices in which ones of said other cells may be placed.

14. The apparatus of any of claims 8-13, wherein said place and route tool is arranged for generating an optimized layout of said other cells based on desired constraints.

15. The apparatus of claim 14, wherein said desired constraints include timing constraints.
